# EUROPÄISCHE PATENTANMELDUNG

(11) **EP 1 826 832 A2**
(43) Veröffentlichungstag der Anmeldung: **29.08.2007**
(21) Anmeldenummer: 07003234.7
(22) Anmeldetag: 15.02.2007
(51) Int. Cl.: H01L 33/00

(54) **Elektronisches Bauteil**

(30) Priorität: 24.02.2006 DE 102006008793
(71) Anmelder: Osram Opto Semiconductors GmbH, 93049 Regensburg (DE)
(72) Erfinder: Behringer, Martin, 93051 Regensburg (DE); Feltges, Harald, 93057 Regensburg (DE); Höfer, Thomas, 39138 Lappersdorf (DE); Möllmer, Frank, 93080 Matting b. Pentling (DE)
(74) Vertreter: Epping - Hermann - Fischer

(57) **Zusammenfassung**

Ein elektronisches Bauteil gemäß der Erfindung umfasst insbesondere einen Gehäusekörper (1), der eine Vertiefung (2) mit einem darin angeordneten optoelektronischen Bauelement (6) aufweist, und eine ein Polyimid aufweisende Folie (3), die so auf der Vertiefung (2) angeordnet ist, dass eine Kavität (5) gebildet wird.

## Beschreibung

Die vorliegende Erfindung betrifft ein elektronisches Bauteil mit einer Folie gemäß dem Oberbegriff des Anspruchs 1 und ein Verfahren zur Herstellung eines elektronischen Bauteils gemäß dem Oberbegriff des Anspruchs 20.

Diese Patentanmeldung beansprucht die Priorität der deutschen Patentanmeldung 102006008793.3, deren Offenbarungsgehalt hiermit durch Rückbezug aufgenommen wird.

Elektronische Bauteile können optoelektronische Bauelemente enthalten, die gegen schädliche Einflüsse, die beispielsweise während des Verarbeitungsprozesses, des Transports, der Handhabung und/oder während des Betriebs auf das optoelektronische Bauelement einwirken können, geschützt werden müssen. Solche schädlichen Einflüsse können etwa durch Verschmutzung in Form von Staub oder Feuchtigkeit oder durch mechanische Beschädigungen, etwa Verkratzen oder Abdrücke, gegeben sein.

In der Druckschrift DE 19536454 A1 ist ein elektronisches Bauteil beschrieben, bei dem ein optoelektronisches Bauelement in einem Gehäusekörper mit einem transparenten Kunststoff umformt ist. Durch diese Umformung kann das optoelektronische Bauelement vor äußeren Beeinträchtigungen geschützt werden. Jedoch können sich bei einem solchen Bauteil nachteilige Effekte auf den Betrieb des elektronischen Bauteils durch die Kunststoffumformung ergeben, beispielsweise durch Brechung oder Beugung insbesondere an den Grenzflächen der Kunststoffumformung oder durch Absorption von Strahlung durch die Kunststoffumformung. Weiterhin kann das mechanische Verhalten wie etwa eine temperaturabhängige Volumenänderung der Kunststoffumformung, beispielsweise beim weiteren Verarbeiten des elektronischen Bauteils durch Löten, einen nachteiligen Effekt für das optoelektronische Bauelement durch eine unerwünschte Druckbeaufschlagung aufweisen.

Eine Aufgabe der vorliegenden Erfindung ist es daher, ein elektronisches Bauteil anzugeben, das die oben genannten Nachteile reduziert oder vermeidet.

Diese Aufgabe wird durch ein elektronisches Bauteil gemäß den Merkmalen des Patentanspruchs 1 gelöst.

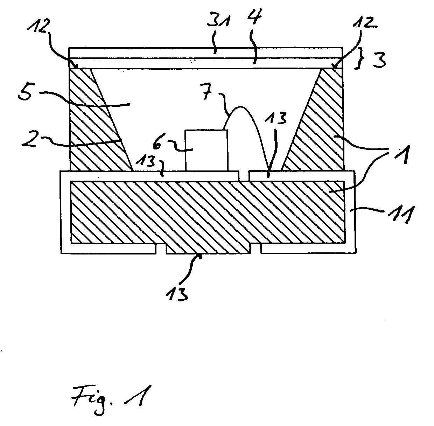

Vorteilhafte Ausführungsformen und Weiterbildungen des elektronischen Bauteils sind in den Unteransprüchen gekennzeichnet und gehen aus der nachfolgenden Beschreibung und der Zeichnung hervor.

Ein elektronisches Bauteil gemäß einer Ausführungsform der Erfindung umfasst insbesondere einen Gehäusekörper, der eine Vertiefung mit einem darin angeordneten optoelektronischen Bauelement aufweist, und eine ein Polyimid aufweisende Folie, die so auf der Vertiefung angeordnet ist, dass eine Kavität gebildet wird.

Ein Polyimid bezeichnet dabei insbesondere ein Polymer mit Imidgruppen als wesentliche Struktureinheiten der Polymer-Hauptkette, wobei die Imidgruppen als lineare oder zyklische Einheiten vorliegen können. Weiterhin kann das Polymer neben den Imidgruppen auch weitere funktionelle Gruppen als Bestandteile der Polymer-Hauptkette aufweisen, beispielsweise Amid-, Ester- und/oder Ethergruppen.

Polyimide können sich durch eine hohe Stabilität und Festigkeit in einem weiten Temperaturbereich auszeichnen. Es kann dabei vorteilhaft sein, wenn das Polyimid eine Temperaturbeständigkeit in einem Temperaturbereich von -75°C bis +260°C aufweist. Weiterhin kann es vorteilhaft sein, wenn das Polyimid eine Temperaturbeständigkeit bis zu einer Temperatur von 370°C aufweist. Dabei kann es vorteilhaft sein, wenn das Polyimid keinen Schmelzpunkt und eine hohe Flammwidrigkeit aufweist. Es kann weiterhin vorteilhaft sein, wenn das Polyimid eine hohe Wärmeformbeständigkeit aufweist, insbesondere eine Schrumpfung von nicht mehr als 0,03 % bei einer Temperatur von 250°C. Durch die hohe Temperaturbeständigkeit und Wärmeformbeständigkeit kann eine ein Polyimid aufweisende Folie beispielsweise innerhalb des Herstellungsprozesses oder der Weiterverarbeitung des elektronischen Bauteils Temperaturen ausgesetzt werden, wie sie üblicherweise bei Lötverfahren auftreten können. Beispielsweise kann dabei als Lötverfahren das Aufschmelzlöten (Reflow-Löten) eine Temperatur von 260°C für einen Zeitraum von fünf bis zehn Sekunden aufweisen.

Die ein Polyimid aufweisende Folie ist so auf dem Gehäusekörper angebracht, dass durch die Vertiefung und die Folie eine Kavität gebildet wird. Das bedeutet, dass die Folie zumindest mit Teilbereichen der Vertiefung einen Hohlraum bildet. Es kann dabei vorteilhaft sein, wenn das optoelektronische Bauelement, das in der Vertiefung angebracht ist, so in der Kavität angebracht ist, dass es in keinem unmittelbaren mechanischen Kontakt zur Folie steht.

Bei einer Ausführungsform des elektronischen Bauteils weist die Vertiefung zumindest teilweise reflektierende Bereiche auf, insbesondere kann die Vertiefung als Reflektortopf ausgeführt sein. Alternativ ist die Vertiefung nicht reflektierend ausgeführt.

Bei einer weiteren Ausführungsform des elektronischen Bauteils ist die Folie mittels einer Klebstoffschicht auf dem Gehäusekörper angebracht. Es kann dabei vorteilhaft sein, wenn der Gehäusekörper eine Fläche aufweist, die sich umlaufend um die Vertiefung befindet und auf der der Klebstoff angebracht ist. Insbesondere kann es vorteilhaft sein, wenn die Fläche nicht gekrümmt ist, wodurch sich eine ebene Verbindungsfläche für die Folie ergibt.

Die Klebstoffschicht und die Folie bedecken dabei vorteilhafterweise die umlaufende Fläche so, dass ein die Vertiefung umschließender Bereich der Folie am Gehäusekörper angebracht ist. Dadurch kann die Kavität von der Folie und der Vertiefung gänzlich eingegrenzt werden. Insbesondere kann es vorteilhaft sein, wenn durch die Folie und die Klebstoffschicht das Eindringen beispielsweise von Staub oder anderen Kleinstpartikeln sowie von Flüssigkeiten und Dämpfen in die Kavität verhindert oder zumindest stark vermindert wird. Dadurch ist es beispielsweise möglich, das elektronische Bauteil in Umgebungen zu verarbeiten oder zu betreiben, die eine nachteilige Wirkung insbesondere für das optoelektronische Bauelement haben. Solche Umgebungen können beispielsweise innerhalb eines Lötprozesses wie etwa einem Aufschmelz-Lötprozess gegeben sein.

Weiterhin kann es vorteilhaft sein, wenn die Klebstoffschicht derart gewählt ist, dass die Kavität nicht hermetisch abgeschlossen wird. Insbesondere kann das vorteilhaft sein, wenn das elektronische Bauteil in Umgebungen verarbeitet wird, in denen es starken Temperaturschwankungen ausgesetzt ist wie sie etwa bei einem Lötprozess auftreten können. Durch eine durch die Folie und die Klebstoffschicht nichthermetisch abgeschlossene Kavität können bei möglichen Temperaturschwankungen Über- oder Unterdrücke in der Kavität verhindert oder vermindert werden, die möglicherweise beispielsweise das optoelektronische Bauelement schädigen können. Beispielsweise kann die Dicke der Klebstoffschicht derart gewählt sein, dass die Kavität nicht hermetisch abgeschlossen ist.

Bei einer weiteren Ausführungsform des elektronischen Bauteils weist die Folie eine erste, das Polyimid aufweisende Schicht und eine zweite Schicht auf. Die zweite Schicht weist einen Klebstoff auf und ist auf dem Gehäusekörper befestigt. Durch das Vorhandensein der zweiten, einen Klebstoff aufweisenden Schicht der Folie kann die Befestigung und Haftung der Folie auf dem Gehäusekörper vorteilhafterweise erleichtert und verbessert werden.

Weiterhin kann es vorteilhaft sein, wenn die Klebstoffschicht einen Silikonklebstoff aufweist oder aus einem Silikonklebstoff besteht. Silikonklebstoffe können eine hohe Temperaturbeständigkeit aufweisen, insbesondere in einem Temperaturbereich von -75°C bis 260°C, bevorzugt bis 370°C. Dadurch kann eine Delamination der Folie durch eine temperaturbedingte Klebstoffdegradation auch bei hohen Temperaturen verhindert werden. Alternativ kann ein Klebstoff auf Silikonbasis, der zusätzlich beispielsweise Epoxide enthält, oder ein Klebstoff auf Epoxidbasis verwendet werden.

Bei einer weiteren Ausführungsform des elektronischen Bauteils ist die Folie oder die erste Schicht der Folie ein Polyimid. Insbesondere kann es vorteilhaft sein, wenn das Polyimid ein Poly-(diphenyloxid-pyromellithimid) aufweist oder ein Poly-(diphenyloxid-pyromellithimid) ist.

Bei einer weiteren Ausführungsform ist die Polyimidfolie als so genannte Kapton-Folie von der Firma DuPont de Nemours erhältlich.

Bei einer weiteren Ausführungsform des elektronischen Bauteils weist die Folie eine Dicke in einem Bereich von 10 bis zu einigen 100 µm auf. Eine geringe Dicke kann sich dabei vorteilhaft auf die Transmissionseigenschaften der Folie hinsichtlich einer Strahlung erweisen, wohingegen sich eine größere Dicke vorteilhaft hinsichtlich der mechanischen Stabilität und damit hinsichtlich des Schutzes beispielsweise vor mechanischen Einwirkungen auf das optoelektronische Bauelement auswirken kann. Bevorzugt weist die Folie eine Dicke von etwa 70 µm auf.

Bei einer weiteren Ausführungsform des elektronischen Bauteils verbleibt die Folie dauerhaft auf dem Gehäusekörper, insbesondere während der Lagerung und des Betriebs des elektronischen Bauteils. Dadurch kann ein unterbrechungsfreier und dauerhafter Schutz für das optoelektronische Bauelement gewährleistet werden.

Bei einer Ausführungsform des elektronischen Bauteils ist die Folie im Strahlengang des optoelektronischen Bauelements angeordnet, d. h. dass die Strahlung auf einer ersten Seite der Folie in die Folie eintritt und auf einer zweiten Seite der Folie aus der Folie austritt. Dabei kann es vorteilhaft sein, wenn die Folie transparent für Strahlung ist. Transparent heißt dabei insbesondere, dass die Strahlung auf der zweiten Seite der Folie mindestens 1 %, bevorzugt mindestens 50 %, besonders bevorzugt mindestens 90 % der Intensität der Strahlung auf der ersten Seite der Folie aufweist.

Bei einer weiteren Ausführungsform des elektronischen Bauteils ist die Folie transparent für Strahlung mit einer Wellenlänge im Bereich von 800 nm bis 900 nm, vorteilhafterweise mit einer Wellenlänge im Bereich von 840 nm bis 860 nm und besonders vorteilhafterweise mit einer Wellenlänge von 850 nm. Insbesondere kann die Folie bei einer Transparenz in einem begrenzten Wellenlängenbereich als spektraler Filter eingesetzt werden.

Weiterhin kann es vorteilhaft sein, wenn die Folie einen Brechungsindex aufweist, der kleiner als der Brechungsindex von Glas ist. Dadurch lassen sich Reflexionsverluste an den Grenzflächen der Folie im Vergleich zu einem im Strahlengang des optoelektronischen Bauelements angeordneten Bauelements, das Glas aufweist oder aus Glas ist, verringern.

Weiterhin kann es vorteilhaft sein, wenn die Folie doppelbrechend ist, insbesondere auch wenn die Folie als Polarisator oder Phasenschieber, beispielsweise als Wellenplatte, für die Strahlung wirkt. Es kann alternativ auch vorteilhaft sein, wenn die Folie keinen Einfluss auf die Polarisation der Strahlung hat.

Bei einer weiteren Ausführungsform des elektronischen Bauteils sind die optischen Eigenschaften der Folie, insbesondere die Transparenz, in einem Temperaturbereich von -40° C bis +100° C unabhängig von der Temperatur.

Bei einer weiteren Ausführungsform des elektronischen Bauteils wirkt die Folie antistatisch. Dies bedeutet insbesondere, dass die Folie eine statische Aufladung von weniger als 150 V, vorzugsweise von weniger als 50 V durch mechanische Einwirkung, beispielsweise Reibung mit gleichem oder anderem Material, aufweist. Dadurch kann die Folie vorteilhafterweise für das optoelektronische Bauelement einen Schutz vor elektrostatischen Entladungen (ESD) aufweisen.

Bei einer Ausführungsform des elektronischen Bauteils ist das optoelektronische Bauelement ein strahlungsemittierendes optoelektronisches Bauelement oder ein strahlungsdetektierendes optoelektronisches Bauelement. Weiterhin kann das optoelektronische Bauelement auch eine Kombination aus strahlungsemittierenden und strahlungsdetektierenden optoelektronischen Bauelementen aufweisen.

Bei einer weiteren Ausführungsform des elektronischen Bauteils umfasst das elektronische Bauteil neben einem ersten optoelektronischen Bauelement mindestens ein zweites optoelektronisches Bauelement. Dabei kann das erste optoelektronische Bauelement ein strahlungsemittierendes optoelektronisches oder ein strahlungsdetektierendes optoelektronisches Bauelement aufweisen und weiterhin kann das zweite optoelektronische Bauelement ein strahlungsemittierendes optoelektronisches oder ein strahlungsdetektierendes optoelektronisches Bauelement aufweisen.

Bei einer weiteren Ausführungsform des elektronischen Bauteils ist das strahlungsdetektierende optoelektronische Bauelement eine Fotodiode, ein Fototransistor oder ein Foto-IC.

Bei einer weiteren Ausführungsform des elektronisches Bauteils ist das strahlungsemittierende optoelektronische Bauelement eine strahlungsemittierende Halbleiterdiode oder eine Halbleiterlaserdiode. Dabei kann die Halbleiterlaserdiode eine kantenemittierende Halbleiterlaserdiode oder eine Vertikalresonatorlaserdiode (VCSEL) sein.

Bei einer Ausführungsform des elektronischen Bauteils ist der Gehäusekörper oberflächenmontierbar. Dabei kann es vorteilhaft sein, wenn des elektronische Bauteil auf einer Außenseite elektrische Kontakte aufweist. Alternativ kann das elektronische Bauteil auch ein bedrahtetes elektronisches Bauteil sein, das mittels Durchkontaktierungen auf einem geeigneten Substrat durch Löten befestigt werden kann.

Bei einer weiteren Ausführungsform des elektronischen Bauteils umfasst oder besteht der Gehäusekörper aus Kunststoff.

Bei einer Ausführungsform eines Verfahrens zur Verkapselung eines elektronischen Bauteils umfasst das Verfahren die folgenden Verfahrensschritte:
A) Bereitstellen eines elektronischen Bauelements mit einem Gehäusekörper, der eine Vertiefung mit einem darin angeordneten optoelektronischen Bauelement aufweist, und
B) Aufbringen einer ein Polyimid aufweisenden Folie so auf der Vertiefung, dass eine Kavität (5) gebildet wird.

Bei einer weiteren Ausführungsform des Verfahrens umfasst das Verfahren vor dem Verfahrensschritt B) die weiteren Verfahrensschritte
A1) Bereitstellen eines ein Polyimid aufweisenden Folienbandes, und
A2) Heraustrennen der Folie aus dem Folienband durch Schneiden und/oder Stanzen
auf.

Durch das Bereitstellen eines Folienbandes, aus dem die Folie herausgetrennt wird, kann vorteilhafterweise ein vereinfachtes Verfahren zum Aufbringen von Folien auf eine Vielzahl von Gehäusekörpern, die beispielsweise auf einem Band oder einem Gurt angeordnet sind, ermöglicht werden.

Weiterhin kann es vorteilhaft sein, wenn eine aus dem Folienband herausgetrennte Folie mittels einer Vakuumpipette aufgenommen wird und auf dem Gehäusekörper auf der Vertiefung aufgebracht wird. Dabei kann insbesondere eine hohe Genauigkeit in der Positionierung der Folie auf dem Gehäusekörper ermöglicht werden.

Bei einer weiteren Ausführungsform des Verfahrens wird der Gehäusekörper nach dem Aufbringen der Folie auf einem Substrat aufgebracht. Dabei kann das Substrat eine Leiterplatte oder eine andere Struktur aufweisen, die eine elektrische Anschlussmöglichkeit für den Gehäusekörper bereitstellt. Vorteilhafterweise kann das Aufbringen und elektrische Kontaktieren des elektronischen Bauteils durch einen Lötprozess erfolgen, insbesondere durch einen Aufschmelzlötprozess. Weiterhin kann eine elektrische Kontaktierung durch einen elektrisch leitenden Klebstoff erfolgen. Vor bei dem Aufbringen und Kontaktieren entstehenden Dämpfen oder Flüssigkeiten, die einen nachteiligen Effekt auf das optoelektronische Bauelement haben können, kann das optoelektronische Bauelement vorteilhafterweise durch die Folie geschützt werden.

Bei einer weiteren Ausführungsform wird die Folie vor der Inbetriebnahme des elektrischen Bauteils von dem Gehäusekörper entfernt.

Weitere Vorteile und vorteilhafte Ausführungsformen und Weiterbildungen der Erfindung ergeben sich aus den im Folgenden in Verbindung mit der einzigen Figur der Anmeldung beschriebenen Ausführungsbeispielen.

Dabei zeigt die Figur eine schematische Schnittdarstellung eines elektronischen Bauteils.

Bei einem Ausführungsbeispiel gemäß der Figur handelt es sich um ein elektronisches Bauteil, das einen Gehäusekörper 1 mit einer Vertiefung 2 aufweist. Der Gehäusekörper 1 ist dabei oberflächenmontierbar. Der Gehäusekörper 1 ist beispielsweise ein durch einen Formprozess erhältlicher Gehäusekörper 1 aus einem Kunststoff, etwa einem Thermoplast, in den ein Leiterrahmen 11 integriert ist. Der Leiterrahmen ist so in den Gehäusekörper 1 integriert, dass in der Vertiefung 2 über einen Bonddraht 7 elektrische Anschlussmöglichkeiten 13 für ein oder mehrere optoelektronische Bauelemente 6 bestehen. Die Vertiefung 2 ist kegelstumpfförmig ausgebildet. Alternativ kann die Vertiefung 2 jede beliebige Form annehmen, z. B. zylinderförmig oder quaderförmig oder in einer Form, die eine Kombination aus Kegelstümpfen, Zylindern und Quadern aufweist, ausgebildet sein. Der Gehäusekörper 1 ist weiterhin so ausgebildet, dass er eine um die Vertiefung 2 umlaufende, nicht-gekrümmte Fläche 12 parallel zur Bodenfläche der Vertiefung 2 aufweist.

Über der Vertiefung 2 ist eine Folie 3 mit einer ersten Schicht 31 aus einem Polyimid und einer zweiten Schicht 4, die eine Klebstoffschicht ist, so aufgebracht, dass die Folie 3 die Vertiefung 2 abdeckt und dabei die Kavität 5 gebildet wird, die von der Folie 3 und der Vertiefung 2 begrenzt wird. Dazu erstreckt sich die Folie 3 über die Vertiefung 2 hinaus auch über die Fläche 12. Die Klebstoffschicht 4 steht dabei in Kontakt mit der Polyimid-Schicht 31 der Folie 3 und der Fläche 12.

Bei dem Polyimid der Schicht 31 handelt es sich um ein Poly-(diphenyloxid-pyromellithimid), bei der Klebstoffschicht 4 um einen Silikonklebstoff, wobei die Folie 3 so ausgeführt ist, dass die Schicht 31 und die Klebstoffschicht 4 zu einem Polyimidfolienklebeband verarbeitet sind das beispielsweise von der Firma 3M erhältlich ist. Die Dicke der Folie 3 beträgt 70 µm.

Um sich nicht nachteilig auf die weiteren Verarbeitungs- und Handhabungsschritte des elektronischen Bauteils auszuwirken, ist es wichtig, dass die Folie eine laterale Ausdehnung im Verhältnis zu der lateralen Ausdehnung des Gehäusekörpers derart aufweist, dass die Folie nicht mehr als 50 µm an den Rändern des elektronischen Bauteils, insbesondere demzufolge über die Fläche 12 hinaus ragt. Die laterale Ausdehnung bezeichnet dabei die Ausdehnung beispielsweise der Folie 3 oder des Gehäusekörpers 1 in einer Ebene parallel zur Montagefläche 13 des Gehäusekörpers. Dafür kann ein passendes Folienstück 3 aus dem Folienband ausgestanzt werden und mittels einer Vakuumpipette auf der Fläche 12 des Gehäusekörpers 1 aufgesetzt werden, was eine hohe Genauigkeit hinsichtlich der Foliengröße und der Position der Folie 3 auf dem Gehäusekörper 1 ermöglicht.

Durch die einfache Verarbeitbarkeit der Folie 3 erweist sich die Folie 3 vorteilhaft in Handhabung und Verarbeitungskosten, beispielsweise im Gegensatz zu einer auf dem Gehäusekörper mittels einer zusätzlich aufzutragenden Klebstoffschicht zu befestigenden Glasplatte, während eine vergleichbare Schutzfunktion wie durch eine Glassplatte für ein optoelektronisches Bauelement 6 gewährleistet werden kann.

Durch die Folie 3 und die Vertiefung 2 weist das elektronische Bauteil eine Kavität 5 auf, die durch die auf der die Vertiefung umschließende Fläche 12 anhaftende Klebstoffschicht 4 abgeschlossen ist. Auf vorteilhafte Weise ist die Dicke der Klebstoffschicht derart gewählt, dass die Kavität nicht hermetisch abgeschlossen ist. Dadurch ist ein Druckausgleich in der Kavität beispielsweise bei durch Temperaturschwankungen des Bauteils und/oder der Umgebungstemperatur auftretenden Über- oder Unterdrücken in der Kavität möglich.

Durch die hohe Wärme- und Chemikalienstabilität der Folie 3 aufgrund der das Polyimid aufweisenden Schicht 31 ist die Kavität 5 auch bei Bedingungen wie hohen Temperaturen und Dämpfen, beispielsweise von Lösungsmitteln oder anderen Chemikalien, geschützt. Dabei ist die Folie 3 stabil in einem Temperaturbereich von -75°C bis +260°C. Alternativ kann die Folie 3 auch stabil bei Temperaturen bis zu 370°C sein. Solche Bedingungen können beispielsweise auftreten, wenn das elektronische Bauteil vorzugsweise durch einen Aufschmelz-Lötprozess auf ein Substrat aufgelötet wird. Durch eine geringe Schrumpfung der Folie 3 bei hohen Temperaturen, beispielsweise 0,03 % bei 250°C, kommt es zu keiner wesentlichen Verformung der Folie 3. Damit kann eine Delamination der Folie 3 von der Fläche 12 vermieden werden.

Beispielsweise kann die Folie 3 auch so ausgeführt sein, dass sie antistatisch wirkt. Das bedeutet insbesondere, dass sich die Folie 3 bei der Handhabung und Verarbeitung nicht oder nur wenig statisch auflädt, wodurch ein zusätzlicher Schutz für das optoelektronische Bauelement gewährleistet werden kann. Die Folie 3 weist dabei einen Schutz bis zu einer Durchschlagspannung von 7 kV auf.

Bei dem optoelektronischen Bauelement 6 handelt es sich um eine Vertikalresonatorlaserdiode (VCSEL). VCSEL-Dioden zeichnen sich dadurch aus, dass die Emissionsrichtung der Laserstrahlung senkrecht zu ihrer Halbleiterschichtenfolge erfolgt und sind beispielsweise in den Druckschriften WO 02/13334 A2 und DE 10026262 A1 beschrieben, deren Offenbarungsgehalt hiermit diesbezüglich aufgenommen ist. Zum Schutz der VCSEL-Diode kann das optoelektronische Bauelement 6 weiterhin eine oder mehrere parallel geschaltete ESD-Schutzdioden aufweisen, so etwa beispielsweise Halbleiterdioden, Fotodioden oder Fototransistoren. Alternativ kann die Halbleiterschichtenfolge der VCSEL-Diode eine oder mehrere integrierte ESD-Schutzdioden aufweisen, wie beispielsweise in den Druckschriften DE 102004005269 B4 und DE 19945134 A1 dargelegt, deren Offenbarungsgehalt hiermit diesbezüglich aufgenommen ist. Die elektrische Kontaktierung der VCSEL-Diode erfolgt an der Unterseite der VCSEL-Diode direkt auf einer elektrischen Kontaktierunsmöglichkeit 13 des Leiterrahmens 11 und an der Oberseite der VCSEL-Diode über einen Bonddraht 7 an einer weiteren elektrischen Kontaktierungsmöglichkeit 13.

Die VCSEL-Diode weist ein Emissionsmaximum bei einer Wellenlänge von 850 nm auf. Die Abmessungen der VCSEL-Diode betragen beispielsweise ungefähr 250 µm Kantenlänge und 150 bis 200 µm Dicke. Der Gehäusekörper 1 weist in lateraler Richtung eine Kantenlänge von ungefähr 3,2 +/- 0,2 mm und ungefähr 2,8 +/- 0,2 mm auf. Die Höhe des Gehäusekörpers 1 beträgt ungefähr 1,9 +/- 0,2 mm. Die Tiefe der Kavität 5 beträgt, vorgegeben durch die Vertiefung 2 im Gehäusekörper 1, ungefähr 0,8 +/- 0,1 mm.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Elektronisches Bauteil mit
- einem Gehäusekörper (1), der eine Vertiefung (2) mit einem darin angeordneten optoelektronischen Bauelement (6) aufweist, und
- einer ein Polyimid aufweisenden Folie (3), die so auf der Vertiefung (2) angeordnet ist, dass eine Kavität (5) gebildet wird.

2. Bauteil nach Anspruch 1, wobei die Folie (3) mittels einer Klebstoffschicht (4) auf dem Gehäusekörper (1) angebracht ist.

3. Bauteil nach Anspruch 1 oder 2, wobei die Folie (3) mindestens eine erste, das Polyimid umfassende Schicht 31 und eine zweite Schicht umfasst, wobei die zweite Schicht eine Klebstoffschicht (4) aufweist und auf dem Gehäusekörper (1) angeordnet ist.

4. Bauteil nach einem der Ansprüche 2 oder 3, wobei die Klebstoffschicht (4) einen Silikon-Klebstoff aufweist.

5. Bauteil nach einem der vorherigen Ansprüche, wobei die Folie (3) oder die erste Schicht (31) der Folie (3) ein Polyimid ist.

6. Bauteil nach einem der vorherigen Ansprüche, wobei das Polyimid ein Poly-(diphenyloxid-pyromellithimid) ist.

7. Bauteil nach einem der vorherigen Ansprüche, wobei die Folie (3) eine Dicke von 70 Mikrometern aufweist.

8. Bauteil nach einem der vorherigen Ansprüche, wobei die Folie (3) im Betrieb des Bauteils auf dem Gehäusekörper (1) verbleibt.

9. Bauteil nach einem der vorherigen Ansprüche, wobei die Folie (3) im Strahlengang des optoelektronischen Bauelements angeordnet ist.

10. Bauteil nach einem der vorherigen Ansprüche, wobei die Folie (3) transparent für Strahlung ist.

11. Bauteil nach Anspruch 10, wobei die Folie (3) transparent für Strahlung mit einer Wellenlänge im Bereich von 800 nm bis 900 nm ist.

12. Bauteil nach Anspruch 10 oder 11, wobei die Transparenz der Folie (3) bei Temperaturen im Bereich von -40°C bis 100°C temperaturunabhängig ist.

13. Bauteil nach einem der vorherigen Ansprüche, wobei die Folie (3) antistatisch ist.

14. Bauteil nach einem der vorherigen Ansprüche, wobei das optoelektronische Bauelement (6) ein strahlungsdetektierendes optoelektronisches Bauelement oder ein strahlungsemittierendes optoelektronisches Bauelement ist.

15. Bauteil nach Anspruch 14, wobei das strahlungsdetektierende optoelektronische Bauelement eine Photodiode, ein Phototransistor oder ein Photo-IC ist.

16. Bauteil nach Anspruch 14, wobei das strahlungsemittierende elektronische Bauelement eine strahlungsemittierende Halbleiterdiode oder eine Halbleiterlaserdiode ist.

17. Bauteil nach Anspruch 16, wobei die Halbleiterlaserdiode eine Vertikalresonator-Laserdiode (VCSEL) ist.

18. Bauteil nach einem der vorherigen Ansprüche, wobei der Gehäusekörper (1) oberflächenmontierbar ist.

19. Bauteil nach einem der vorherigen Ansprüche, wobei der Gehäusekörper (1) aus Kunststoff ist.

20. Verfahren zur Verkapselung eines elektronischen Bauteils mit den Verfahrensschritten:
A) Bereitstellen eines elektronischen Bauteils mit einem Gehäusekörper (1), der eine Vertiefung (2) mit einem darin angeordneten optoelektronischen Bauelement (6) aufweist, und
B) Aufbringen einer ein Polyimid aufweisenden Folie (3) so auf der Vertiefung (2), dass eine Kavität (5) gebildet wird.

21. Verfahren nach dem vorherigen Anspruch, bei dem das Verfahren vor dem Verfahrensschritt B) weiterhin die folgenden Verfahrensschritte umfasst:
A1) Bereitstellen eines ein Polyimid aufweisenden Folienbandes, und
A2) Heraustrennen der Folie (3) aus dem Folienband durch Schneiden und/oder Stanzen.

22. Verfahren nach einem der beiden vorherigen Ansprüche, bei dem der Verfahrensschritt B) die folgenden Verfahrensschritte umfasst:
B1) Aufnehmen der Folie (3) mittels einer Vakuumpipette, und
B2) Aufbringen der Folie (3) mittels der Vakuumpipette über der Vertiefung (2).

23. Verfahren nach einem der Ansprüche 20 bis 22, bei dem der Gehäusekörper (1) nach dem Aufbringen der Folie (3) weiterhin auf einem Substrat aufgebracht wird.

24. Verfahren nach dem vorherigen Anspruch, bei dem das Substrat eine Leiterplatte umfasst.

25. Verfahren nach einem der beiden vorherigen Ansprüche, bei dem der Gehäusekörpers auf dem Substrat mittels Aufschmelzlöten aufgebracht wird.

26. Verfahren nach einem der Ansprüche 20 bis 25, bei dem die Folie (3) vor Inbetriebnahme des elektronischen Bauteils vom Gehäusekörper entfernt wird.
